**Europäisches Patentamt**

**European Patent Office**

**Office européen des brevets**

(11) Publication number: **0 089 604**
**B1**

# EUROPEAN PATENT SPECIFICATION

(45) Date of publication of patent specification: **17.12.86**

(21) Application number: **83102539.0**

(22) Date of filing: **15.03.83**

(51) Int. Cl.⁴: **C 23 C 14/04,** C 23 C 26/00,
C 04 B 41/51 // H01L21/88,
H01L21/288, H05K3/00

(54) **Method for selectively coating metallurgical patterns on dielectric substrates.**

(30) Priority: **18.03.82 US 359469**
**18.03.82 US 359445**

(43) Date of publication of application:
**28.09.83 Bulletin 83/39**

(45) Publication of the grant of the patent:
**17.12.86 Bulletin 86/51**

(84) Designated Contracting States:
**DE FR GB**

(56) References cited:
**DE-A-2 745 581**
**DE-B-2 443 287**
**DE-B-2 453 035**
**US-A-3 945 113**

(73) Proprietor: **International Business Machines
Corporation
Old Orchard Road
Armonk, N.Y. 10504 (US)**

(72) Inventor: **Kumar, Ananda Hosakere
6 Dorett Drive
Wappingers Falls New York 12590 (US)**
Inventor: **Srikrishnan, Kris Venkatraman
Lydia Drive
Wappingers Falls New York 12533 (US)**

(74) Representative: **Oechssler, Dietrich, Dr. rer. nat.
Schönaicher Strasse 220
D-7030 Böblingen (DE)**

Courier Press, Leamington Spa, England.

## Description

The invention relates to a method for selectively depositing metal over an existing metallurgical pattern supported on or recessed in a dielectric substrate.

The multi-layer ceramic (MLC) technology for fabricating dielectric substrate carriers for integrated circuit/semiconductor package assemblies is well known. Such MLC substrates are produced by preparing a slurry of a suitable ceramic particulates (e.g. alumina), a fugitive resin binder material, a solvent for the resin binder, normally with an included plasticizer; doctor blading the slurry on removable base with subsequent drying to form thin flexible sheets commonly termed ceramic green sheets. The sheets are then punched to form via holes, and the via holes filled with conductive metalliferous (e.g. molybdenum) paste which is also formed into a pattern of conductive lines which will ultimately form the internal circuitry of the MLC. The punched and printed green sheets are selectively stacked on each other into a laminated substrate assembly, as for example, a stack of 15 to 30 green sheets, and the assembly sintered to integrate the sheets and develop the conductor pattern while removing the binder. The resultant fired MLC substrate can then be employed for flip-chip mounting of semiconductor devices which are electrically connected to the internal circuitry of the MLC substrate.

External contact with the MLC substrate is made by a plurality of I/O pins normally brazed or otherwise mounted to the opposite side of the MLC substrate to the internal circuitry thereof. It is desirable that the MLC substrate be formed with vias and lines densified in accordance with the corresponding microminiaturization of the integrated circuit developments. Such microminiaturization is desirable in order that the package be compatible with the corresponding densified integrated circuit device chips mounted thereon. In such application the MLC substrate must be provided on the top surface with many small pads which are capable of making registered electrical contact with correspondingly closely spaced semiconductor device terminals, e.g. solder mounds. In order to more efficiently use the modern integrated circuit technology, as many as possible integrated circuit devices are supported on and interconnected within the MLC substrate. Such an arrangement keeps the distances between interconnected devices small and thereby minimizes the time it takes for electrical signals to travel between the interrelated devices. Also this reduces the number of electrical connections which must be made thereby reducing the cost of the package and increases reliability. The end result is a highly complex MLC package with a lot of small internal printed circuitry contained in a substrate carrier capable of mounting large numbers of integrated circuit devices.

Further, such MLC substrates require a relatively complex metallurgy on the topside to make electric connection to integrated circuit devices and to provide engineering change pads, and on the bottom side to make connection to the I/O pads, pins or other type connections. When green ceramic is sintered there is normally a 17 to 20% shrinkage. Frequently, the shrinkage is not uniform throughout the MLC substrate. Since the substrate is relatively large, and the metallurgy geometry quite small, it is difficult and frequently impossible to produce a mask for coating protective diverse metals on the substrate metallurgy, that is 17 to 20% smaller than the original substrate that will have all open areas that will coincide or register with the substrate metallurgy. Such as mask is necessary for depositing additional metallurgy metals using conventional masking techniques. Usually the original metallurgy pattern on the MLC substrate laminate deposited prior to sintering comprises a refractory (for example molybdenum) metalliferous paste screened on the laminate sheets. After sintering, the refractory metal (e.g. molybdenum, tungsten, etc.) must not only be protectively covered with different metals, as for example nickel, chromium, copper, gold, etc., but also to facilitate the making of connections, as by soldering, to semiconductor devices, compression bonding to wires and/or brazing to I/O pins. The protective coating of the refractive MLC substrate metallurgy, where molybdenum is employed is important, since molybdenum is susceptible to reactive corrosion when exposed to humidity of any pH value at operating potentials common in MLC module or substrate applications. This corrosion interrupts conductors, and leads to module failure.

One method of protecting the substrate metallurgy is by covering them with diverse metals, e.g. nickel, by electroless plating techniques which do not require masks. However, such coatings are usually thin and may contain impurities such as phosphorous, boron, etc., which may be objectionable in subsequent joining (e.g., soldering, brazing, compression bonding, etc).

The protective metal layers can also be deposited by electroplating techniques. However, such plating techniques require electrical connection to each area to be plated, whereas in MLC substrates such connections are not always available, since some pads or portions of the metallurgy pattern can be "electrically floating".

These electroless and electroplating techniques are expensive time consuming and difficult to control; and thus there is a need for a maskless plating technique which is simple with elimination of processing steps as well as having a significant improvement in yield without problems of phosphorous and/or boron contamination.

It is the object of the invention to provide a maskless, clean method for selectively metal coating an existing metallurgical pattern on a dielectric substrate with diverse metals or alloys.

This object is achieved by a method as defined at the beginning of this specification having the features of the characterizing part of claim 1.

The inventive method does not have the drawbacks of the electroless selective plating methods, nor the restrictions of the electrochemical selective plating methods. The inventive method is particularly useful in coating a protective metal on refractive metal conductive patterns on or recessed in ceramic substrate carriers employed for mounting semiconductor devices. Preferably the invention provides a maskless method for cladding sintered refractory metal circuit features on or recessed in ceramic substrates with a solderable and brazeable protective coating for connection to terminal contacts of an integrated circuit device and to input/output (I/O) pins.

In one advantageous embodiment of the invention the following process steps are executed

A) sequentially blanket coating said substrate, inclusive of said pattern with discrete levels of diverse metals having a differential in melting points (a) bondable to said pattern, (b) non-wetting to the unpatterned surface of said substrate, with the metal having the lowest melting point disposed adjacent said substrate;

B) heating the then present structure to a temperature above the melting point of the lowest melting metal;

C) cooling said structure to delaminate the metal deposit on the unpatterned surface areas of said substrate; and

D) removing said delaminated deposit from the unpatterned surfaces areas of said substrate to retain a bonded cladding comprising said metals on said metallurgical pattern.

In another advantageous embodiment of the invention the following process steps are executed:

A) sequentially blanket coating said substrate, inclusive of said pattern, with discrete levels of diverse alloyable metals showing a negative deviation from Raoult's law in their phase diagram, with the alloy of said metals bondable to said pattern and non-wetting to the unpatterned surface areas of said substrate;

B) heating the then present structure to a temperature below the melting points of said metals and above the lowest liquidus temperature in the phase diagram of the alloy system of said metals whereby a cladding of said metals is bonded to said pattern and forms loosely adhered segments on said bare surfaces of said substrate;

C) cooling said structure; and

D) removing said segments from said unpatterned surfaces of said substrate.

Other advantageous embodiments of the inventive method are disclosed in the subclaims.

The invention will become more apparent from the following detailed description taken in conjunction with the accompanying drawings.

Figs. 1 to 5 show schematically in cross-sectional views, and broken sections, various stages of the method according to one advantageous embodiment of the invention.

Figs. 6 to 8 are phase diagrams of, respectively palladium/nickel, gold-nickel and copper/gold alloy systems.

Figs. 9 to 13 are schematic cross-sectional views showing various stages of the method according to another advantageous embodiment of the invention.

Fig. 14 photographically shows the maskless coating produced by said another advantageous embodiment to a metallurgical via pattern of a dielectric substrate.

Fig. 15 photographically shows the maskless coating produced by said another advantageous embodiment to engineering change (EC) pads of a dielectric substrate.

Fig. 16 photographically shows a cross-section through a dielectric substrate with a via metallization provided with a coating produced by said another advantageous embodiment.

The liquid metallic layer required in the inventive method is preferably produced in one of two ways. These two ways are described in the following by means of two embodiments of the inventive method. However, the inventive method is not restricted to these two embodiments. With both embodiments of the inventive method suitable alloy coatings are deposited on refractory metal patterns supported on or recessed in the substrate. These alloy coatings enable further brazing and soldering to these features.

First Embodiment

The method according to the first embodiment involves depositing by such techniques as vacuum evaporation or sputtering over the entire substrate surface discrete layers of two metals which can form a continuous series of solid solutions whose *solidus* temperatures lie between the melting temperatures of the pure metals, the metal with the lower melting point being deposited first, heating the substrate at a suitably fast heating rate to slightly above the melting point of the metal of the lower melting point to cause this layer to melt and wet to the surfaces of the refractory metal features and concurrently, to dewet from the ceramic surface, cooling to room temperature and selectively removing the now non-adhering metal coating on the unpatterned ceramic regions of the substrate surface by subjecting the surface to the action of intense ultrasonic vibrations in an inert liquid medium such as water, leaving a strongly adherent coating of an alloy of the two metals deposited only on the refractory metal features. Apart from the solid solution behavior noted above, the choice of the two metals is governed by (i) the need for good wetting and bonding of the lower melting metal to the refractory metal surfaces and (ii) the need to ensure that the resulting alloy coating provides for joining to these features through the use of common, low temperature braze and solder alloys. It is to be understood that although the ultrasonic vibration technique is the preferred method for selectively removing the nonadherent metal layer from the ceramic surface after the heat treatment step, other techniques such as light scrubbing with a brush or vapor blasting can also be used to accomplish this.

Although many binary alloy systems satisfy the criterion for the solid solution behavior of the type noted above, illustrative of two such systems are Cu-Pd and Cu-Ni are particularly suited for this application because (i) molten copper wets molybdenum very well, forming a strong braze bond to it and (ii) the resulting alloys are easily joined to using common brazing and soldering alloys. As a special case, we can also obtain a single metal coating, e.g. of copper, as opposed to an alloy coating by first depositing copper on the substrate followed by depositing a thin coating of a refractory metal such as molybdenum, which does not form any intermetallics or solid solutions with copper, heat treating as above to slightly above the melting point of copper, removing the nonadhering metal film on the deramic by ultrasonic agitation, followed by selectively etching off the molybdenum layer from the adhering copper surface using a suitable etchant.

The principles of the method will now be illustrated by taking the examples of the metals copper (melting point 1083°C) and palladium (melting point 1575°C). After thoroughly cleaning the substrate surface to be rid of any oil films by standard degreasing methods, a layer of copper (1—3 μm) is first deposited over its entire surface followed by a layer of a palladium (1—3 μm) in the same pumpdown in an Ebeam evaporator. The substrate is then heated in a nitrogen or forming gas ambient to 1100°C at a heating rate of at least 5°C/min., held at this temperature for 5 minutes and cooled at a convenient rate to room temperature. During the heating stage of this heat treatment, interdiffusion between copper and palladium layers takes place giving rise to a series of solid solutions ranging in composition from pure palladium at the top to pure copper at the bottom closest to the substrate surface. The heating rate used is such that, for the thicknesses of the metal layers chosen, when the maximum heat treating temperature is reached the composition of the metal layer adjacent to the substrate surface will be either pure copper or a dilute alloy of palladium in copper whose solidus temperature is exceeded by the chosen peak heat treating temperature. Under these circumstances a thin liquid metal zone is formed next to the substrate surface during the heat treatment with at least the top layers of the composite film remaining solid. The formation of this captive liquid zone instantaneously causes it to wet the molybdenum surfaces and concurrently to dewet from the bare ceramic surface. After this is accomplished, longer holding at the peak temperature would merely tend to homogenize the composition through the composite film without undoing the selective bonding (to the refractory metal features) and debonding (from the bare ceramic) that had already occurred. The upper bound for the peak heat treatment temperature chosen should be such that the solidus temperature of the completely homogenized copper-palladium alloy should be safely above this temperature so as not to melt the entire film. Upon cooling the substrate to room temperature a continuous copper-palladium alloy film will exist on the substrate surface, this film adhering strongly to the refractory metal features on this surface while staying nonadhering to the bare ceramic in the manner of a conventional decal. Upon subjecting this surface to the action of intense ultrasonic vibrations in an insert medium such as water, the nonadherent portions of the film quickly break off from the adherent regions and fall off from the ceramic surface leaving only the self-aligned, adherent alloy coating on the refractory metal features. This is how the objective of selectively coating the refractory metal features on the substrate surface with an adherent coating of a copper-palladium alloy conductive to joining to associated elements through the use of common, low temperature brazing and soldering alloys, was achieved without using any selective masking steps.

The essential condition for the success of this process is the promotion of selective adhesion of the deposited films to the refractory metal features on the substrate surface while concurrently causing this film to debond from the bare ceramic surface. To bring this about the following conditions were needed: (i) The choice of two suitable metals of widely differing melting points which form a continuous series of solid solutions whose solidus curve lies intermediate between the melting points of the two component metals, (ii) The first metal to be deposited on the substrate surface should be the metal whose melting point is lower of the two, and which in the molten state wets as well the refractory metal to be coated, (iii) This thicknesses of the deposited layers and the heating rate chosen being such as to ensure the formation of a temporary liquid layer next to the substrate surface at or below the peak heat treatment temperature while the top portions of the composite film remains unmolten, (iv) The relative thicknesses of the metal layers are chosen to ensure that the solidus temperature of the completely homogenized alloy stays safely above the peak heat treating temperature and (v) The total thickness of the coating, while chosen to be adequate for subsequent joining of associated elements to the refractory metal features, should not be excessive so as not to need excessive times of ultrasonic vibration exposure for the removal of the parts of the film rendered nonadherent to the bare ceramic surface by the heat treatment.

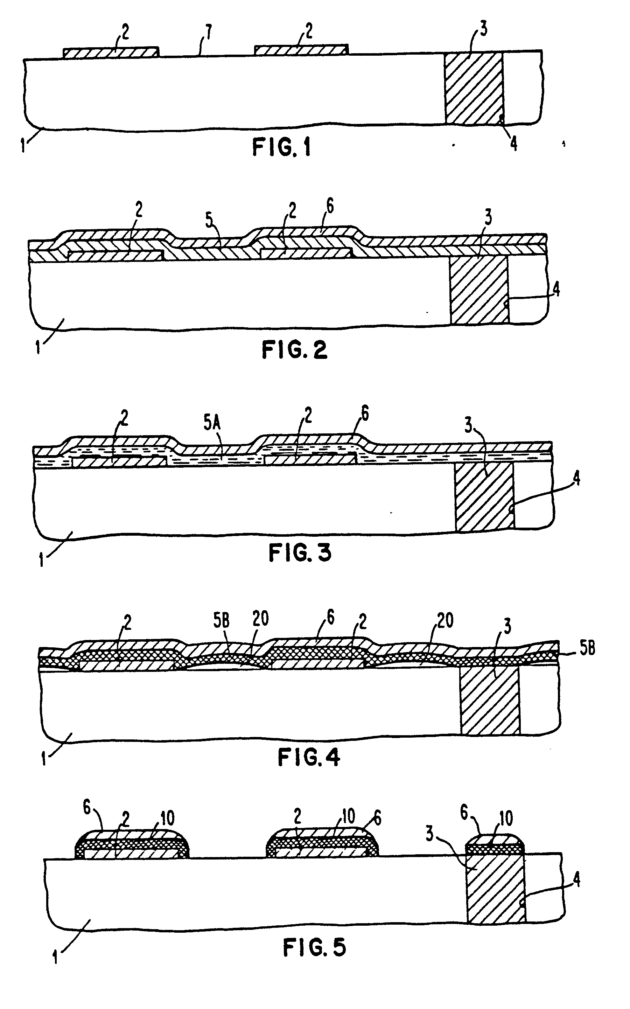

Referring to Fig. 1, there is depicted a fired ceramic substrate 1, typically a multilayered ceramic substrate which can be produced by the method described in detail in US Patent 3 518 756. Although Figs. 1 to 5 are illustrated in broken section, the internal metallurgical conductor pattern is not shown since it does not constitute a material part of the invention. It is also to be understood, however, that substrate 1 need not be a multilayer ceramic substrate, but could be solid with the metallurgical layers formed entirely on the surfaces. The material of substrate 1 is normally formed of alumina, or alumina plus other materials (such as glass), or a ceramic glass material. The surface of substrate 1 shows metallurgy areas 2 and 3 (of via hole 4) which are normally formed of a refractory metal (such as a molybdenum based metal) which was deposited prior to sintering of substrate 1.

For one development of the first embodiment of the invention, the substrate 1, inclusive of metallurgy circuit features 2 and 3, are blanket coated to a thickness of about 2 to about 5 μm, as by sputtering and vacuum evaporation, with a low melting point metal (e.g. copper M.P. 1083°C). The low melting point layer 5, is in turn suitably coated with a blanket layer 6 of a higher melting point metal to a thickness of about 2 to about 5 μm. The metal of layer 6 can be any suitable higher melting metal such as palladium, platinum, and nickel which form a continuous series of solid solutions with copper with the solidus points of all such solid solutions lying intermediate between the melting point of copper (1083°C) and the melting point of the metal chosen for layer 6. Also, the top metal layer 5 can also comprise a refractory metal such as molybdenum, tungsten and the like. It is only necessary that the low melting point bottom metal layer 5 which will, in its liquid form wet the circuit features 2 and 3, and dewet the bare or unpatterned surface areas 7 of substrate 1.

The composite metal 5/6 coated substrate is then heated to a temperature between the melting points of the bottom and top (5 and 6) layer metallization, whereby the top layer 6 remains as a nonliquid solid film sandwiching against substrate 1, a captive liquid zone 5A formed of the molten layer 5. For a system utilizing a bottom copper layer 5 and a top palladium or nickel layer 6, the substrate can be heated to about 1100—1140°C.

With the use of a refractory metal, such as molybdenum for top layer 6 in conjunction with a bottom copper layer 5, the structure can be heated to about 1100°C. Although the temperature of the heat treatment will vary with the system of the top and bottom layers 5/6, it can extend in the range from the melting point of the metal of layer 5 to the solidus temperature of the alloy formed by the complete mixing of layers 5 and 6.

During heat treatment the molten bottom metal layer 5A brazes or bonds to the molybdenum circuit features 2 and 3, while dewetting the unpatterned surface areas 7 of substrate 1, on contact therewith where it debands at 20, on cooling from the substrate surface. The solidified liquid alloy is identified as 5B.

After cooling, the metallization of bottom and top layers 5 and 6, can be suitably removed as by sand blasting and wire brushing, or by subjecting the substrate to an ultrasonic cleaning operation or other suitable medium, in a conventional tank type of ultrasonic cleaner having side and/or bottom mounted transducers.

In the absence of the more refractory palladium layer or the copper layer, the latter would be completely molten at the peak heat treating temperature and would freely flow on the uneven surface of the substrate forming puddles bridging over closely spaced refractory metal features at the low spots on this surface, these bridges remaining as solid copper bridges across these features upon cooling. The molten copper will also form a multitude of small spherical droplets on the ceramic surface which will remain as copper spheres tenaciously attached to the asperities on the ceramic surface. Thus the presence of the more refractory palladium (or nickel) over the liquid metal layer during the heat treatment (Fig. 3) acts to prevent the latter's tendency for lateral flow on the substrate surface, as well as to prevent the balling up of the molten copper on the ceramic because it will remain spread on the solid metal crust. If during the heat treatment no liquid zone is formed, which can happen if the peak heat treatment temperature attained is below the melting temperature of the alloy composition closest to the ceramic surface at the instant of reaching that temperature, no selective bonding of the film to the molybdenum surface will occur. Such a condition could arise if (i) the heating rate is so slow as to allow considerable penetration of palladium into the region of the copper layer adjacent to substrate surface prior to attaining the peak heat treating temperature (ii) the thickness of the copper layer is not adequate for the heating rate employed, to prevent excessive palladium penetration into the copper layer prior to reaching the peak temperature for the heating rate employed. Thus the critical heating and the copper layer thickness are interdependent. These also depend on the rate of change of the solidus temperature with composition (i.e., the slope of the solidus curve) on the copper-rich side of the binary phase diagram for the two metals and on their interdiffusion rates. Thus, the gentler slope of the solidus curve in the copper-palladium system would allow for a greater degree of palladium penetration into copper layer prior to reaching the peak heat treating temperature, than in the case of the copper-nickel system which exhibits a steeper solidus curve.

The relative thicknesses of the copper and palladium (nickel) layers should be so chosen as to ensure that the solidus temperature of the completely homogenized alloy that will result from their eventual, complete mixing be safely above the peak temperature chosen for the heat treatment to prevent its complete melting at this temperature. In the case where the top layer chosen is such that it does not form any intermetallics or solid solution with the layer below (e.g., molybdenum over copper), the top layer thickness need only be sufficient to prevent the breakout of the molten copper through it during the heat treatment. The mechanism of film removal involves the rupturing of the loose metal film 5 from the substrate areas by the action of the shock waves impinging on the surfaces. The shock waves being induced by bubble collapse (cavitation) within the liquid medium during the ultrasonic action. One preferred form of removing the metal film 5 is by use of an ultrasonic horn to focus and deliver very high local intensities of energy (about 100 watts per cm²) and by utilizing the near field characteristics of the ultrasonic field close (e.g. about 1 to about 10 mm) to the horn surface where cavitation plays only a minor role. In such an arrangement, the removal of the loosely adherent metal films 5 from the substrate surface is very efficient. For example, non-adhering copper-palladium films of 5 μm thickness can be removed from alumina ceramic surfaces in about 5 to about 30 seconds.

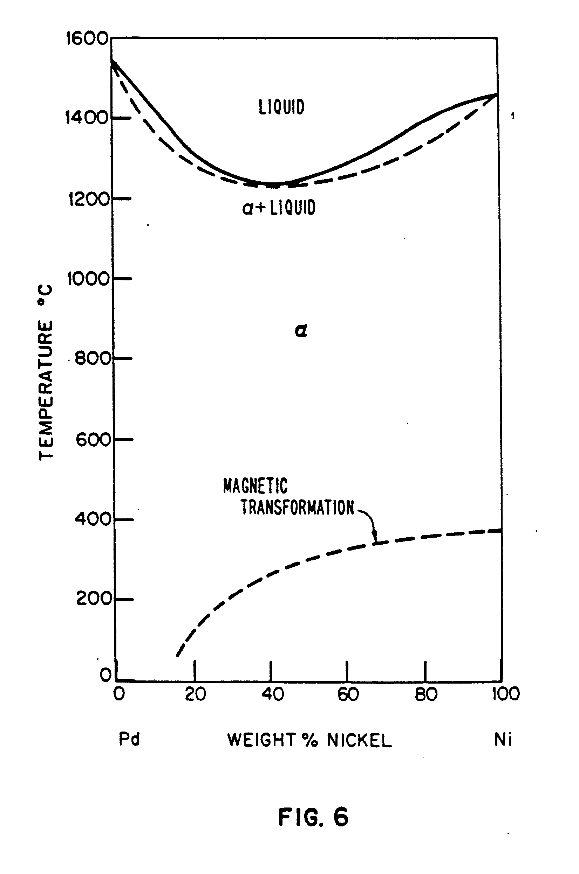

It is believed that the mechanism of metal film removal is as follows: In the near-field region, there exists a coupling of ultrasonic field (generated by the transducer) to the surface of the substrate carrying the metal film. Where the metal film 5 is strongly adhering to the substrate, such as in areas of the pre-existing metallurgical circuit features under the film, the ultrasonic energy is merely transmitted through the metal film 5 into the substrate and dissipated. Where the metal film 5 is non-adhering, such as on the bare substrate surface areas, the ultrasonic energy is substantially absorbed by the thin metal film 5, causing it to vibrate with the field. This vibration generates alternating stresses at points of the film where it adheres to the substrate which eventually causes the film breakage at these points. High frequencies (e.g., 10—40 KHz) of the field ensures that from $10—40 \times 10^3$ cycles of alternating stress is applied to the metal film 5 at the boundaries of adhering regions so that the fatigue limit for the film is reached in 1 to 30 seconds depending on the nature of the metal film, its thicknesses, and the distance between adjacent adhering areas. With the complete removal of the non-adhering metal film 5 from the substrate surfaces, only the pre-existing metallurgical circuit features on the substrate will retain an adherent metal film 6, as shown in Fig. 5.

Where a refractory metal is employed as the top layer 6, it can be removed from the final structure, where desired or required, by suitable wet or dry etching techniques.

Where limitations of heating furnaces and heat-up and cool-down present problems of temperature exposures, one effective method of heating is by E-beam. Use of an E-beam will heat the substrate to temperature very quickly with subsequent rapid cooling. Illustratively, the structure can be heated with a pulsed electron beam or laser beam to locally heat up the metal layers and cause melting of the bottom metal layer 5 in small areas in a very short time. Since the heat duration is quite small, the MLC substrate should not feel appreciable thermal shock. After the E-beam or laser heat treatment, the unwanted regions (e.g., over the unpatterned surface areas 7 of substrate 1) can be removed by various techniques.

Illustratively the Cu-Pd alloy capping of the circuit features 2 and 3, a 2 μm film of copper was used for bottom layer 5 with a blanket coating of 1 μm of palladium for the top layer 6, the unit was heat treated to 1100°C in a forming gas ambient as follows:

2 1/2 hours heating time to 1100°C
5 minutes hold at 1100°C
Furnace, off to cool

The substrate was subsequently cleaned ultrasonically to completely remove the non-adhering alloy film on the unpatterned surface areas 7 of an alumina ceramic substrate 1. An adherent Cu-Pd alloy cladding remained on the molybdenum circuit features 2 and 3.

Second Embodiment

The method according to the second embodiment enables the selective coating of surface metal features of di-electric substrate with a cladding of diverse metals or their alloys to obtain desired characteristics such as solderability, brazeability and/or corrosion resistance. The coatings are formed first by blanket deposition over the substrate, inclusive of existing metallurgical pattern features, with pattern definition occurring solely due to a subsequent heat treatment in a suitable ambient.

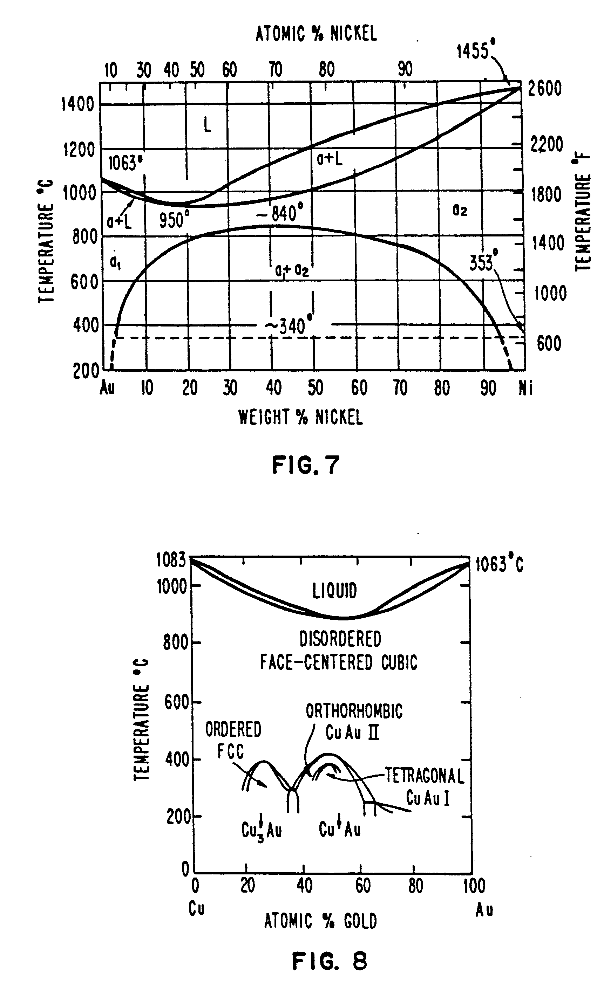

For bimetallic coatings, two suitable alloyable metals are chosen which form a continuous series of solid solutions showing a negative deviation from Raoult's law. Illustrative of these systems are the combinations Pd/Ni, Au/Ni and Au/Cu as shown in their respective phase diagrams of Figs. 6—8. These metal systems when molten, dewet the substrate surface with good wetting and adhesion to the metallurgical pattern surfaces. The coated substrate is heated to a temperature ($T_H$) above the lowest liquidus line of the metal coatings but below the melting points of either pure metal component. Due to heating, the metal coatings interdiffuse to form a range of compositions which are changing with time. The thin layer in the dual coating whose composition can melt below $T_H$ becomes liquid, and with time this molten zone can move up or down; and when it reaches the surfaces of the substrate and the metallurgical pattern, localized selective adhesion is obtained, e.g. on the pattern but not on the bare substrate surfaces. At this point the surface tension of the liquid zone causes a metal film to strongly braze on bond to the metallurgical pattern and to debond from the bare substrate surfaces, from which, after cooling, it can be mechanically removed as by wire brushing, light sand blasting and, preferably, ultrasonically.

For example, in application to the semiconductor art utilizing an alumina MLC substrate having molybdenum based circuit features, the specifically noted alloy systems are particularly advantageous. Illustrative or these systems is palladium and nickel which forms an excellent brazing alloy for molybdenum, since it is solderable and brazeable while providing effective corrosion resistance for molybdenum. The heat treatment can be effected at a $T_H$ of about 1250 to about 1300°C, which can be accommodated in the temperature hierarchy of the processes and materials of the MLC. The temperature of heat treatment is chosen by reference to the phase diagram, as for example Fig. 6 for Pd/Ni system. This temperature should be at or slightly above the lowest liquidus temperature in the system, which for the Pd/Ni system is 1250°C at a 60% Pd/ 40% Ni composition. The choice of solid solution systems exhibiting a negative deviation from Raoult's law need only enable a heat treatment temperature that should lie above the liquidus line in the system but not exceed the melting points of either pure metal component.

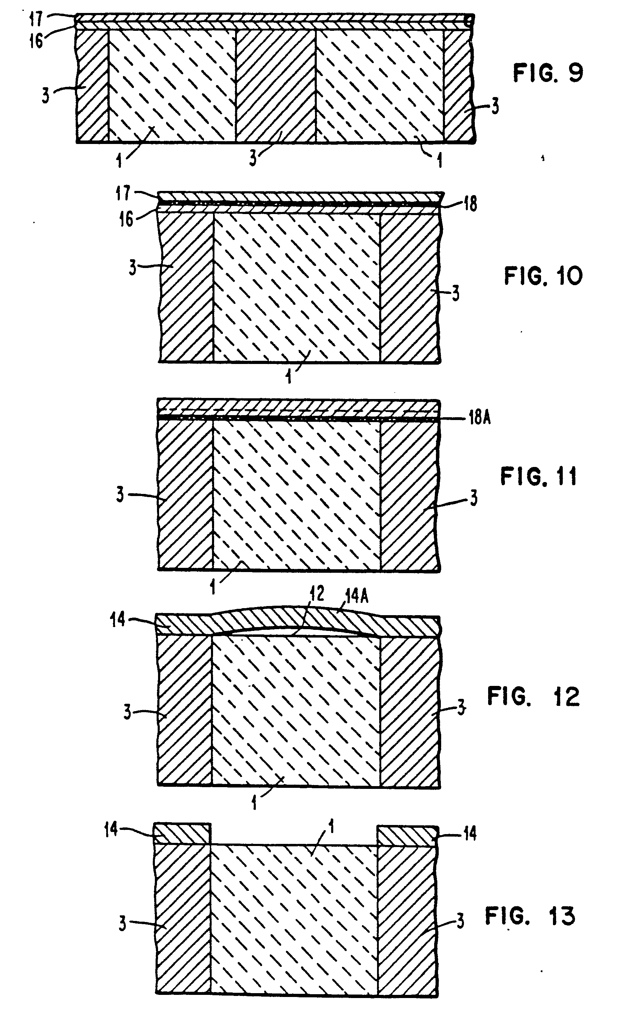

During heat treatment of the illustrative Pd/Ni system, the component metals interdiffuse forming a series of solid solutions across the coating thickness. When a particular segment of this interdiffused region attains the composition 60% Pd/ 40% Ni, this segment will become liquid. As the interdiffusion continues, the thin liquid zone 18 (Fig. 10) initially formed at the Pd-Ni interface will further enrich itself with palladium or nickel causing it to freeze. However, another segment in the diffusion zone will now be at the critical composition and will melt. This dynamic process continues repeatedly, with the effect of moving a thin liquid zone 18 gradually towards the substrate surface, to, in effect, form a floating zone moving to the substrate, see 18A, Fig. 11.

When this floating zone (Fig. 11) reaches the surface of the existing metallurgy (e.g. molybdenum) of the substrate, it will wet the metal and cause the alloy deposit to braze to it. However, when simultaneously the liquid zone reaches the bare or unpatterned substrate surfaces, it will dewet from the surface (e.g. alumina ceramic), and the strong tension forces will cause the deposit to debond from the surfaces (Fig. 12). The debonded metal layer portion 14A from the ceramic surface 12 can be easily removed, as by brushing and, preferably, ultrasonic cleaning in which only the metallurgical pattern 3 will be selectively coated with an adherent Pd/Ni alloy layer 14 (Fig. 13).

Referring to Figs. 9 to 13, there is shown a fired ceramic substrate 1, typically an alumina based multilayered ceramic substrate which can be produced by the method described in detail in US Patent 3 518 756. Although Figs. 9 to 13 are illustrated in broken section, the internal metallurgical conductor pattern is not shown in detail since it does not constitute a material part of the invention. Also, it is to be understood, however, that substrate 1 need not be a multilayer ceramic substrate, but could be solid with the metallurgical pattern formed entirely on the surfaces. However, for this embodiment a portion of the metallurgical pattern, of an MLC, is shown in the context of via extensions or studs 3, which can be formed of a refractory based metal, such a molybdenum which was deposited in a via of the substrate 1 before its firing. The material of the substrate 1 is typically formed of alumina or alumina plus other materials (such as glass), or a ceramic glass material.

The substrate 1, inclusive of the metallurgical features 3, are blanket coated in an E-beam evaporation system sequentially with 1—5 µm thick coatings of a nickel film 16 and a palladium film 17, in that order. However, as noted above, the dual coatings can comprise other systems, such as Au/Ni, Au/Cu, which conform to this invention. The thickness of the films need not be the same, and each may vary in thicknesses of about 1 to about 5 µm.

The composite metal 16/17 coated substrate is subsequently heat treated in an $H_2$ ambient at temperatures of 1300—1350°C, holding at this peak temperature for 2 hours. Although most thin metallic films (in the micron range), evaporated or sputtered, exhibit poor discrimination in adhesion between the substrate surfaces (e.g. ceramic) and the metallurgical pattern (e.g. molybdenum) liquid metals and their alloys (e.g. Cu, Cu/Pd, Au etc.), on the other hand wet the metallurgical pattern (Mo) and dewet the substrate (e.g., ceramic) substrate. The layer thicknesses of Pd and Ni and the peak heat treatment temperatures will be so chosen that the latter lies safely below the solidus point for the completely homogenized Pd-Ni alloy that results.

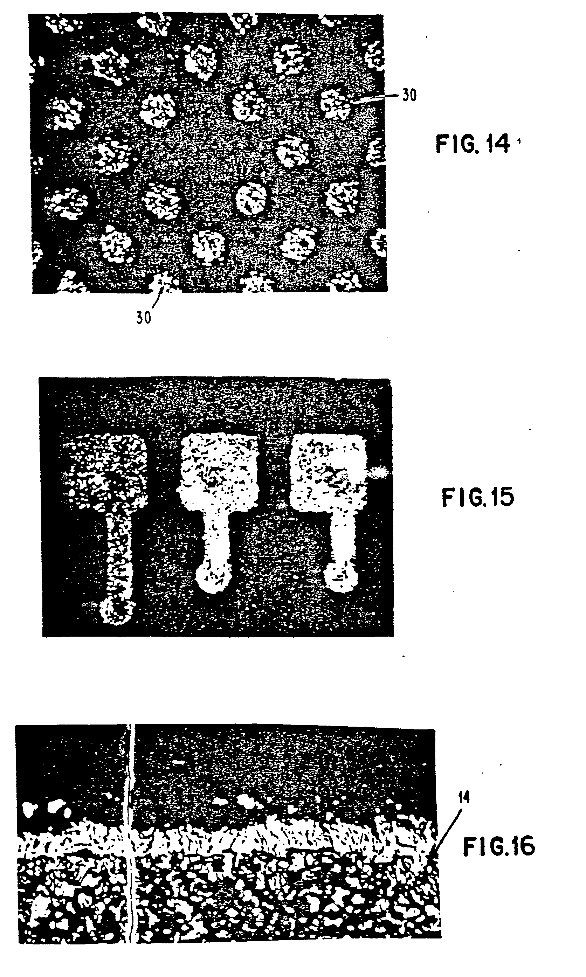

On cooling of the substrate a layer of palladium-nickel alloy will remain over the surface of the substrate, this layer having become strongly adherent to the refractory metal features in the substrate while delaminating from the bare ceramic areas of the substrate surface. The delaminated portions of the alloy film can be easily detached from the surface by light sand blasting, wire brushing or ultrasonic cleaning. The results are displayed in Figs. 14 and 15 which, respectively, show the via regions and EC pads, of a sample, showing Pd/Ni coated molybdenum circuit features and the absence of any bridge in between the conductors. Fig. 16 shows a cross-section through a via 30 confirming the formation of a continuous adherent layer 14 of Pd/Ni alloy.

The ultrasonic cleaning can be effected by conventional methods utilizing suitable mediums in a conventional tank type of cleaners having side and or bottom mounted transducers. The mechanism of film removal in ultrasonic cleaning involves the rupturing of the loose metal film areas 14A from the substrate areas by the action of the shock waves impinging on the surfaces. The shock waves being induced by bubble collapse (cavitation) within the liquid medium during the ultrasonic action. One preferred form of removing the metal film areas 14A is by use of an ultrasonic horn to focus and deliver very high local intensities of energy (about 100 watts per $cm^2$) and by utilizing the near field characteristics of the ultrasonic field close (e.g. about 1 to about 10 mm) to the horn surface where cavitation plays only a minor role. Under such conditions, the removal of the loosely adherent metal film areas 14A from the substrate surface is very efficient. For example, non-adhering palladium-nickel films of 5 μm thickness can be removed from alumina ceramic surfaces in about 5 to about 30 seconds.

It is believed that the mechanism of metal film removal is as follows; in the near-field region, there exists a coupling of the ultrasonic field (generated by the transducer) to the surface of the substrate carrying the metal film. Where the metal film 14 is strongly adhering to the substrate, such as in areas of the pre-existing metallurgical circuit features under the film, the ultrasonic energy is merely transmitted through the metal film 14 into the substrate and dissipated. Where the metal film 14 is non-adhering, such as on the bare substrate surface areas, the ultrasonic energy is substantially absorbed by the thin metal film 14, causing it to vibrate with the field. This vibration generates alternating stresses at points of the film where it adheres to the substrate which eventually causes the film breakage at these points. High frequencies (e.g. 10—40 KHz) of the field ensures that from 10—40 × 10³ cycles of alternating stress is applied to the metal film 14 at the boundaries of adhering regions so that the fatigue limit for the film is reached (in 1 to 30 seconds) depending on the nature of the metal film, its thicknesses, and the distance between adjacent adhering areas. With the complete removal of the non-adhering metal film areas 14A from the substrate surfaces, only the pre-existing metallurgical circuit features 3 on or recessed in the substrate will retain an adherent metal film 14, as shown in Fig. 16.

## Claims

1. Method for selectively depositing metal over an existing metallurgical pattern supported on or recessed in a dielectric substrate, characterized by the following steps:

A) sequentially blanket coating said substrate and said pattern with metals tuned to another in such a way that on heating a liquid metal or alloy layer is formed adjacent the substrate and pattern surface which said layer wets said pattern but not said substrate,

B) heating the then present structure to a temperature where the said liquid metal or alloy layer is formed;

C) cooling said structure to solidify said liquid metal or alloy layer and to delaminate the metal deposit on the unpatterned surface areas;

D) removing the metal deposit from the unpatterned surface areas of said substrate to retain a bonded cladding comprising said metal deposit on said metallurgical pattern.

2. Method according to claim 1, wherein said metal coatings consist of brazeable and solderable metals.

3. Method according to claim 1 or 2, wherein said dielectric substrate comprises a ceramic.

4. Method according to any one of claims 1 to 3, wherein said metallurgical pattern comprises a refractory metal.

5. Method according to claim 4, wherein the refractory metal is selected from the group of molybdenum and tungsten.

6. Method according to any one of claims 1 to 5, wherein said metal deposit is ultrasonically removed from the unpatterned surface areas of said substrate.

7. Method according to any one of claims 1 to 6, wherein

in the step (A) said substrate (1) and said pattern (2, 3) are sequentially blanket coated with discrete levels of diverse metals having a differential in melting points (a) bondable to said pattern (b) non-wetting to the unpatterned surface (7) of said substrate (1), with the metal having the lowest melting point disposed adjacent said substrate; and

in the step (B) the heating is carried out to a temperature above the melting point of the lowest melting metal.

8. Method according to claim 7, wherein said diverse metals form alloy systems and show a behaviour according to Raoult's law or a positive deviation from it and wherein the temperature in said heating steps does not exceed the liquidus temperature of any resultant completely homogenized alloy corresponding to their amounts of metals deposited.

9. Method according to claim 7 or 8, wherein the substrate (1) adjacent metal is selected from the group of copper, nickel, nickel/palladium alloy and copper/palladium alloy.

10. Method according to claim 7, wherein

in the step (A) a blanket coating of a first metal layer (5) is deposited over said substrate (1), inclusive of said pattern (2, 3) with said first metal layer (5) having a melting point lower than that of the pattern and being adherent thereto; and then

a blanket coating of a second metal layer (6) is deposited over said first metal layer (5), with said second metal layer (6) having a melting point higher than that of said first metal (5); and

in the step (B) the heating is carried out to below the melting point of said second metal layer (6) and above that of said first metal layer (5) for selective melting thereof.

11. Method according to claim 10, wherein said first metal layer (5) is selected from the group of copper, nickel and gold based metals.

12. Method according to claim 10 or 11, wherein said second metal layer (6) comprises a refractory metal.

13. Method according to claim 12, wherein the step of selective removal of said second metal layer (6) by wet or dry etching from the cladding on said pattern (2, 3) is included.

14. Method according to any one of claims 1 to 6, wherein

in the step (A) said substrate (1) with said pattern are sequentially blanket coated with discrete levels of diverse alloyable metals (16, 17) showing a negative deviation from Raoult's law in their phase diagram with the alloy of said metals bondable to said pattern and non-wetting to the unpatterned surface areas (12) of said substrate; and

in the step (B) the heating is carried out to a temperature below the melting point of said metals (16, 17) and above the lowest liquidus temperature in the phase diagram of the alloy system of said metals (16, 17), whereby a cladding of said metals (16, 17) is bonded to said pattern and forms loosely adhered segments (14A) on said unpatterned surface areas (12) of said substrate (1).

15. Method according to claim 14, wherein said metals are selected to form one of Pd/Ni, Au/Ni and Au/Cu binary alloy systems.

16. Method according to claims 14 or 15, wherein said metallurgical pattern comprises contact points on the surfaces of said substrate (1) for solder or brazing elements thereto.

17. Method according to any one of claims 14 to 16, wherein said substrate (1) is a multilayer ceramic.

## Patentansprüche

1. Verfahren zum selektiven Aufbringen von Metall über einem vorhandenen metallurgischen, auf einem dielektrischen Substrat aufliegenden oder in es eingelegten Muster, gekennzeichnet durch die folgenden Schritte:

A) ganzflächiges Beschichten des Substrats und des Musters der Reihe nach mit Metallen, die so aufeinander abgestimmt sind, daß sich bei Erwärmung eine flüssige Metall- oder eine Legierungsschicht angrenzend an die Oberfläche von Substrat und Muster bildet, wobei die Schicht das Muster, aber nicht das Substrat benetzt,

B) Erwärmen der resultierenden Struktur auf eine Temperatur, in welcher sich die Schicht aus flüssigem Metall oder der Legierung bildet,

C) Abkühlen der Struktur um die flüssige Metall- oder Legierungsschicht zum Erstarren zu bringen, und um die Metallabscheidung auf den Oberflächenbereichen ohne Muster zu delaminieren,

D) Entfernen der Metallabscheidung von den Flächenbereichen ohne Muster, so daß ein aus der Metallabscheidung bestehender Überzug auf dem metallurgischen Muster verbleibt.

2. Verfahren nach Anspruch 1, worin die Metallbeschichtungen aus hart lötbaren und weich lötbaren Metallen bestehen.

3. Verfahren nach Anspruch 1 oder 2, worin das dielektrische Substrat aus einem Keramikmaterial besteht.

4. Verfahren nach einem der Ansprüche 1 bis 3, worin das metallurgische Muster ein hoch schmelzendes Metall enthält.

5. Verfahren nach Anspruch 4, worin das hoch schmelzende Metall aus der Gruppe von Molybdän und Wolfram gewählt wird.

6. Verfahren nach einem der Ansprüche 1 bis 5, worin die Metallabscheidung mit Ultraschall von den Flächenbereichen ohne Muster entfernt wird.

7. Verfahren nach einem der Ansprüche 1 bis 6, worin im Schritt (A) das Substrat (1) und das Muster (2, 3) nacheinander ganzflächig mit diskreten Schichten verschiedener Metalle beschichtet werden, die unterschiedliche Schmelzpunkte haben, die (a) mit dem Muster Verbindungen eingehen und (b) die musterlose Oberfläche (7) des Substrats (1) nicht benetzen, wobei das Metall mit dem niedrigsten Schmelzpunkt direkt auf dem Substrat aufgebracht wird, und

worin im Schritt (B) auf eine Temperatur oberhalb des Schmelzpunktes des am niedrigsten schmelzenden Metalls erwärmt wird.

8. Verfahren nach Anspruch 7, in welchem die verschiedenen Metalle Legierungssysteme bilden und sich gemäß dem Raoultschen Gesetz oder einer positiven Ableitung hiervon verhalten, und worin die Temperatur der Erwärmungsschritte die mit den Mengen der niedergeschalgenen Metalle korrespondierende Liquidustemperatur jeder resultierenden, völlig homgenisierten Legierung nicht überschreitet.

9. Verfahren nach Anspruch 7 oder 8, worin das direkt auf dem Substrat (1) aufgebrachte Metall aus der Gruppe von Kupfer, Nickel, eine Nickel-Palladiumlegierung und einer Kupfer/Palladiumlegierung gewählt wird.

10. Verfahren nach Anspruch 7, worin im Schritt (A) eine erste Metallschicht (5) ganzflächig auf dem Substrat (1) einschlielich dem Muster (2, 3) aufgebracht wird, wobei die erste Metallschicht (5) einen niedrigeren Schmelzpunkt als das Muster aufweist und daran anhaftet, und worin eine zweite Metallschicht (6) über der ersten Metallschicht (5) ganzflächig aufgebracht wird, wobei die zweite Metallschicht (6) einen höheren Schmelzpunkt aufweist als die erste Metallschicht (5), und worin im Schritt (B) auf eine Temperatur unterhalb des Schmelzpunktes der zweiten Metallschicht (6) und oberhalb des Schmelzpunktes der ersten Metallschicht (5) erwärmt wird, um die letztere selektiv zu schmelzen.

11. Verfahren nach Anspruch 10, worin die erste Metallschicht (5) aus der Gruppe Kupfer, Nickel und Metallen auf Goldbasis ausgewählt wird.

12. Verfahren nach Anspruch 10 oder 11, worin die zweite Metallschicht (6) aus einem hoch schmelzenden Metall besteht.

13. Verfahren nach Anspruch 12, einschließlich des Schrittes des selektiven Entfernens der zweiten Metallschicht (6) durch nasses oder trockenes Ätzen von dem Überzug des Musters (2, 3).

14. Verfahren nach einem der Ansprüche 1 bis 6, worin im Schritt (A) auf das Substrat (1) und das Muster ganzflächig der Reihe nach mit diskreten Schichten Ebenen verschiedener legierbarer Metalle (16, 17) mit einer negativen Ableitung des Raoultschen Gesetzes in ihrem Phasendiagramm aufgebracht werden, wobei die Legierung des genannten Metalls mit dem Muster Bindungen eingeht und die musterlosen Oberflächenbereiche (12) des Substrats nicht benetzt, und worin im Schritt (B) die Erwärmung auf eine Temperatur vorgenommen wird, die unterhalb der Schmelzpunkte der Metalle (16, 17) und oberhalb der niedrigsten Liquidustemperatur im Phasendiagramm des Legierungssystems der Metalle (16, 17) liegt, wodurch ein Überzug aus den Metallen (16, 17) mit dem Muster verbunden wird und lose haftende Segmente (14A) auf den musterlosen Flächenbereichen (12) des Substrats (1) bildet.

15. Verfahren nach Anspruch 14, worin die Metalle so ausgewählt sind, daß sie eines der binären Pd/Ni, Au/Ni oder Au/Cu enthaltenden Legierungssysteme bilden.

16. Verfahren nach Anspruch 14 oder 15, worin das metallurgische Muster Kontaktpunkte auf den Oberfläche der Substrate (1) enthält, um Elemente hieran hart oder weich zu löten.

17. Verfahren nach einem der Ansprüche 14 bis 17, worin es sich bei dem Substrat (1) um eine Mehrschichtkeramik handelt.

**Revendications**

1. Procédé pour déposer sélectivement un métal sur une configuration métallurgique existante supportée sur un substrat diélectrique ou logée dans ce substrat, caractérisé en ce qu'il consiste à:

A. recouvrir séquentiellement ledit substrat et ladite configuration avec des métaux accordés l'un à l'autre, de sorte que, par chauffage, il se forme une couche de métal ou d'alliage liquide adjacente à la surface du substrat et de la configuration, ladite couche mouillant la configuration mais non le substrat,

B. chauffer la structure ainsi obtenue, à une température à laquelle ladite couche de métal ou d'alliage liquide se forme,

C. refroidir ladite structure pour solidifier ladite couche de métal ou d'alliage liquide et pour désolidariser le dépôt de métal sur les zones de la surface qui ne comportent pas de configuration métallurgique,

D. enlever le dépôt de métal des zones de surface ne comportant pas de configuration métallurgique dudit substrat, de manière à conserver un placage lié constitué par ledit dépôt de métal sur ladite configuration métallurgique.

2. Procédé suivant la revendication 1, dans lequel les revêtements de métal sont constitués de métaux brasables et soudables.

3. Procédé suivant la revendication 1 ou 2, dans lequel ledit substrat diélectrique est constitué d'une céramique.

4. Procédé suivant l'une quelconque des revendications 1 à 3, dans lequel ladite configuration métallurgique est constituée d'un métal réfractaire.

5. Procédé suivant la revendication 4, dans lequel le métal réfractaire est choisi dans le groupe du molybdène et du tungstène.

6. Procédé suivant l'une quelconque des revendications 1 à 5, dans lequel ledit dépôt de métal est enlevé ultrasoniquement des zones de surface du substrat qui ne comportent pas de configuration métallurgique.

7. Procédé suivant l'une quelconque des revendications 1 à 6, dans lequel, dans l'opération (A), ledit substrat (1) et la dite configuration (2, 3) sont recouverts séquentiellement avec des niveaux distincts de divers métaux ayant des points de fusion différents et (a) qui peuvent se lier à ladite configuration et (b) qui ne mouillent pas la surface (7) du substrat (1) exempte de configuration, le métal de plus bas point de fusion étant adjacent au substrat; et, dans l'opération (B), le chauffage est effectué à une température supérieure au point de fusion du métal de plus point de fusion.

8. Procédé suivant la revendication 7, dans lequel lesdits divers métaux constituent des systèmes d'alliage et ont un comportement conforme à la loi de Raoult ou une déviation positive par rapport à cette loi, et dans lequel la température dans lesdites opérations de chauffage ne dépasse pas la température de liquidus de tout alliage résultant complètement homogénéisé correspondant aux quantités des métaux déposés.

9. Procédé suivant la revendication 7 ou 8, dans lequel le métal adjacent au substrat (1) est choisi dans le groupe du cuivre, du nickel, de l'alliage nickel/palladium et de l'alliage cuivre/palladium.

10. Procédé suivant la revendication 7, dans lequel, dans l'opération (A), un recouvrement d'une première couche de métal (5) est déposé sur ledit substrat (1), y compris ladite configuration (2, 3), ladite première couche de métal (5) ayant un point de fusion inférieur à celui de la configuration et adhérant à celle-ci; et en-suite un revêtement d'une deuxième couche de métal (6) est déposé sur ladite première couche de métal (5), la deuxième couche de métal (6) ayant un point de fusion supérieur à celui de la première couche de métal, (5); et, dans l'opération (B), le chauffage est effectué à une température inférieure au point de fusion de la deuxième couche de métal (6) et supérieure à celui de la première couche de métal (5) pour leur fusion sélective.

11. Procédé suivant la revendication 10, dans lequel ladite première couche de métal (5) est choisie dans le groupe du cuivre, du nickel et de métaux à base d'or.

12. Procédé suivant la revendication 10 ou 11, dans lequel ladite deuxième couche de métal (6) est constituée d'un métal réfractaire.

13. Procédé suivant la revendication 12, dans lequel l'opération d'enlèvement sélectif de la deuxième couche de métal (6) par décapage humide ou sec, du placage sur ladite configuration (2, 3) est prévue.

14. Procédé suivant l'une quelconque des revendications 1 à 6, dans lequel, dans l'opération (A), ledit substrat (1) et ladite configuration sont recouverts séquentiellement avec des niveaux distants de divers métaux (16, 17) susceptibles de s'allier et présentant une déviation négative par rapport à la loi de Raoult dans leur diagramme de phase, l'alliage desdits métaux pouvant se lier à ladite configuration et ne mouillant pas les zones (12) de la surface du substrat qui ne comportent pas la dite configuration; et, dans l'opération (B), le chauffage est effectué à une température inférieure au point de fusion desdits métaux (16, 17) et supérieure à la plus basse température de liquidus dans le diagramme de phase du système d'alliage desdits métaux (16, 17), de sorte qu'un placage desdits métaux (16, 17) est lié à ladite configuration et forme des segments peu adhérents (14A) sur les régions (12) de la surface du substrat (1) exemptes de configuration.

15. Procédé suivant la revendication 14, dans lequel lesdits métaux sont choisis de manière à constituer l'un des systèmes d'alliage binaire (Pd/ Ni, Au/Ni et Au/Cu.

16. Procédé suivant la revendication 14 ou 15, dans lequel ladite configuration métallurgique comprend des points de contact sur les surfaces dudit substrat (1), pour y souder ou braser des éléments.

17. Procédé suivant l'une quelconque des revendications 14 à 16, dans lequel ledit substrat (1) est une céramique multicouches.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16